# EUROPEAN PATENT SPECIFICATION

(11) **EP 1 130 773 B1**
(45) Date of publication and mention of the grant of the patent: **03.01.2007**
(21) Application number: 00830154.1
(22) Date of filing: 29.02.2000
(51) Int. Cl.: H03H 17/02, G11B 20/10

(54) **Decoding arrangement of the PRML type and method of filtering signals**
PRML-Dekodieranordnung und Verfahren zur Filterung von Signalen
Arrangement de décodage du type PRML et procédé pour filtrer des signaux

(43) Date of publication of application: 05.09.2001
(73) Proprietor: STMicroelectronics S.r.l., 20041 Agrate Brianza (Milano) (IT)
(72) Inventor: Pisati, Valerio, 27040 Bosnasco (Pavia) (IT); Rossi, Augusto, 27100 Pavia (IT); Betti, Giorgio, 20010 Pogliano Milanese (Milano) (IT); Cazzaniga, Marco, 21027 Ispra (Varese) (IT)
(74) Representative: Botti, Mario

(56) References cited:
- US-A- 4 907 100
- US-A- 5 255 133
- US-A- 5 854 717

## Description

This invention relates to a time-continous FIR filter for implementing a Hilbert transform.

The invention also relates to a method of filtering signals whose spectra are unknown a priori.

In particular, the invention relates to a circuit structure for programmable time-continous analog filters specifically intended for read/write operations from/into magnetic storage media.

One general aspect of the invention is a method of improving a circuit structure -- which structure would implement a Hilbert transform and incorporate a FIR filter -- particularly where the transform is to process input signals whose spectra are unknown a priori. The description which follows only covers this field of application for the sake of simplicity.

### Prior Art

As is well known in this technical field, a circuit structure designed to implement a Hilbert transform has a time-continous FIR (Finite Impulse Response) filter for its basic component.

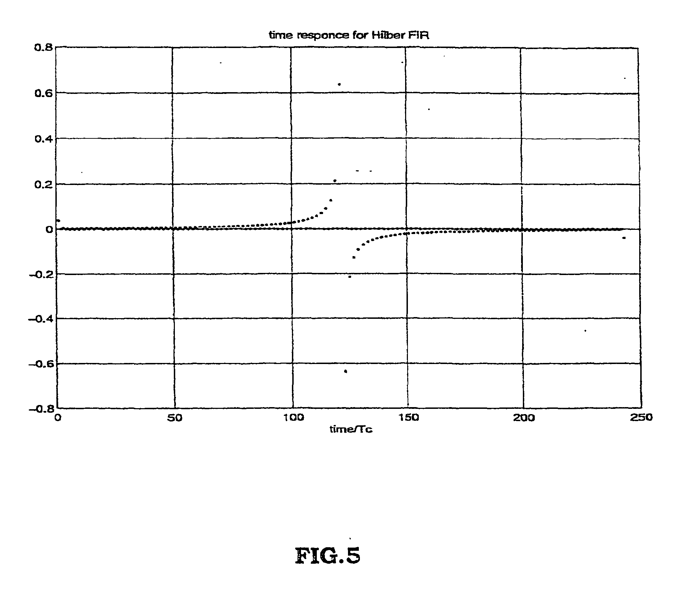

More particularly, a Hilbert transform is essentially a constant module 90° phase shifter, and this characteristic can be implemented by an impulse response FIR filter in the way shown in Figure 5, for example.

The frequency response of such an FIR filter can better approach an ideal response, the greater the filter length provided.

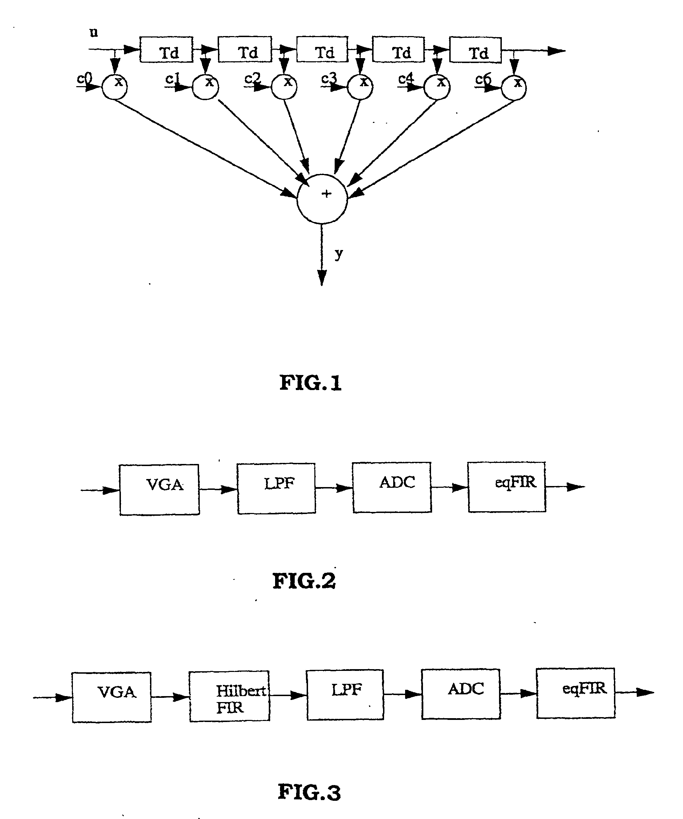

The accompanying Figure 1 shows schematically a conventional FIR filter which includes a plurality of delay cells cascade connected together between an input terminal and an output terminal.

A distinguishing feature of the cells is that they carry the same amount of time delay, designated Td. The signal output from each cell is then multiplied by a predetermined coefficient c0,...,cn.

The summation of all the signals, each multiplied by a respective one of the coefficients c0,...,cn, gives a value Y representing the impulse response of the filter.

The performance of a time-continous FIR filter is also linked to another parameter, that is, the band of the signal being input to the chain of delay cells. The greater the band width, the larger becomes the number of the FIR filter coefficients required for a closer approach to the ideal Hilbert transform.

It is a recognized fact that the frequency response of an amplified signal amplitude is related to the frequency response of the signal phase. As the input signal band grows wider, the phase frequency response becomes smaller, and the so-called group delay is reduced. In fact group delay is the derivative of phase with respect to frequency.

In other words, with an input signal having a broad band, an FIR filter with a very large number of coefficients must be used in order to obtain a desired frequency response. However, this requires fairly complicated and expensive circuit structures, and demanding ones in terms of circuit area.

Furthermore, where the input signal has different spectrum forms, there are no circuit structures available which can handle the frequency response in an optimum manner. It is customary in such cases to adopt either of two different approaches.

A first approach consists in employing a FIR filter which has a fixed number of coefficients c0,...,cn, so that the filter performances are those as desired for all the spectra inputs.

A second approach consists in using a filter having coefficients c0,...,cn which can be programmed to fit the spectrum of the input signal.

The first solution obviously involves a larger number of elements than the second.

However, the basic element in the first approach is bound to be of simpler construction on account of the coefficients being non-programmable.

While being advantageous from several aspects and substantially meeting current requirements, neither the first nor the second of the above solutions fill all the demands of processing input signals whose spectrum is unknown a priori.

There is also a known solution disclosed in the US patent No. 5,255,133 relating to a peak detector using a FIR filter and introducing a constant offset for recovering the peaks shifting. However this solution is not applicable to a PRML system applied to a magnetic storage medium.

A similar solution is known from the US patent No. 4,907,100 concerning a system for optimising a peak detector. Again, this solution may not be applied to a PRML system.

Further, US 5 854 717 shows a decoding arrangement of the PRML type.

The technical problem underlying the present invention is to provide a FIR filter design for implementing a Hilbert transform, which has appropriate structural and functional features to enable processing of signals whose spectra are unknown beforehand, thereby overcoming the limitations and drawbacks of prior art designs.

### Summary of the Invention

The principle behind this invention is one of using a FIR filter with constant coefficients, and optimizing the filter response for the input signal spectrum by modifying the time delay of the cells.

Based on this principle, the technical problem is solved by a decoding arrangement as previously indicated and defined in Claims 1 and the claims dependent therefrom. The technical problem is further solved by a method for filtering signals having spectra unknown beforehand, as defined in Claims 5 and following.

The features and advantages of a decoding arrangement and filtering method according to the invention will be apparent from the following description of preferred embodiments thereof, given by way of a non-limitative example with reference to the accompanying drawings.

### Brief Description of the Drawing

In the drawings:
Figure 1 shows schematically a conventional FIR filter structure;
Figure 2 is a block diagram of a PRLM decoding arrangement according to the prior art;
Figure 3 is a block diagram of a PRLM decoding arrangement according to the invention
Figure 4 shows comparative plots of response vs. time, respectively for longitudinal recording and perpendicular recording signals, relating to the reading of data from magnetic storage media;
Figure 5 is a plot of response vs. time for a Hilbert FIR filter;
Figures 6A and 6B are respective plots of frequency response for components of the decoding arrangement shown in Figure 4
Figures 7A, 7B and 7C are respective plots of frequency response for the Hilbert FIR filter of this invention.

### Detailed Description

Referring to the drawing views, and in particular to the example of Figure 3, the block structure of a Hilbert transform according to this invention is generally shown in schematic form.

One possible application of the invention concerns the method of recording logic information in magnetic storage media, e.g. hard disks. In particular, an object of this invention is to have storage density increased by allowing the logic information to be recorded in the magnetic storage medium along a vertical direction.

This recording method is known as "perpendicular recording" and affords increased storage density for a given area of the magnetic storage medium over "longitudinal recording", the latter being the type of magnetization currently in use. It effectively enhances the storage density of information in magnetic media, such as hard disks.

To decode a signal from longitudinal recording, a decoding arrangement of the Partial Response with Maximum Likelihood type, shown schematically in Figure 2, is usually employed.

A first block VGA is a voltage gain amplifier into which is input a signal from a device arranged to read data from a magnetic storage medium, not shown because conventional.

Connected to the output of the block VGA is a low-pass filter LPF having an analog-to-digital converter ADC placed downstream of it.

An equalizer eqFIR is connected to the output of the converter ADC.

Advantageously in this invention, the arrangement shown in Figure 2 can be modified for processing and decoding signals from perpendicular recording.

On account of the properties of Hilbert transform, in fact, the output signal from a Hilbert filter FIR is quite similar to the input signal to the low-pass filter LPF of Figure 2. Accordingly, the same decoding arrangement as is used for longitudinal recording can be used for perpendicular recording if a Hilbert filter FIR is connected in the block chain.

More particularly, as shown in the example of Figure 3, the Hilbert filter FIR is connected between the block VGA and the low-pass filter LPF.

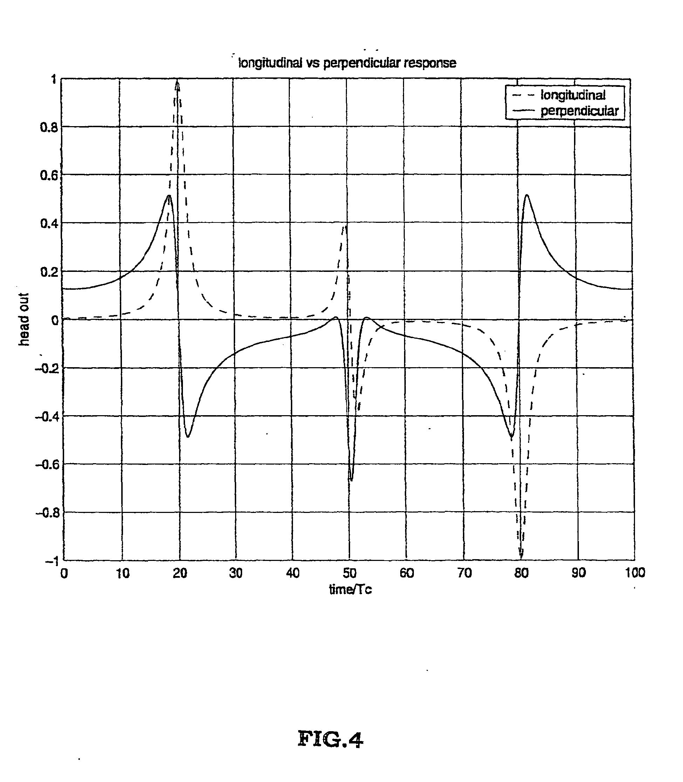

Plotted in Figure 4 is an impulse response relating to two different magnetizations originating from a positive isolated transition, a double transition (d-pulse), and a negative isolated transition.

With the decoding arrangement of this invention shown in Figure 3, the signal indicated by a full line in Figure 4, relating to perpendicular recording, can be converted to a signal like that indicated by a dash line, representative of longitudinal recording.

The transfer function provided by the invention is aimed at minimizing the number of coefficients of the Hilbert FIR by imposing a 90-degree phase shift in the range of interest but accepting a substantially non-constant module.

In essence, to recover a gain variation, particularly a gain attenuation, it was considered of obtaining an increase in gain from another portion of the decoding arrangement. For the purpose, the designs of the low-pass filter LPF and the equalizer eqFIR of Figure 3 have been altered, with respect to an ideal Hilbert filter, to compensate for the less-than-ideal performance of the near-Hilbert filter.

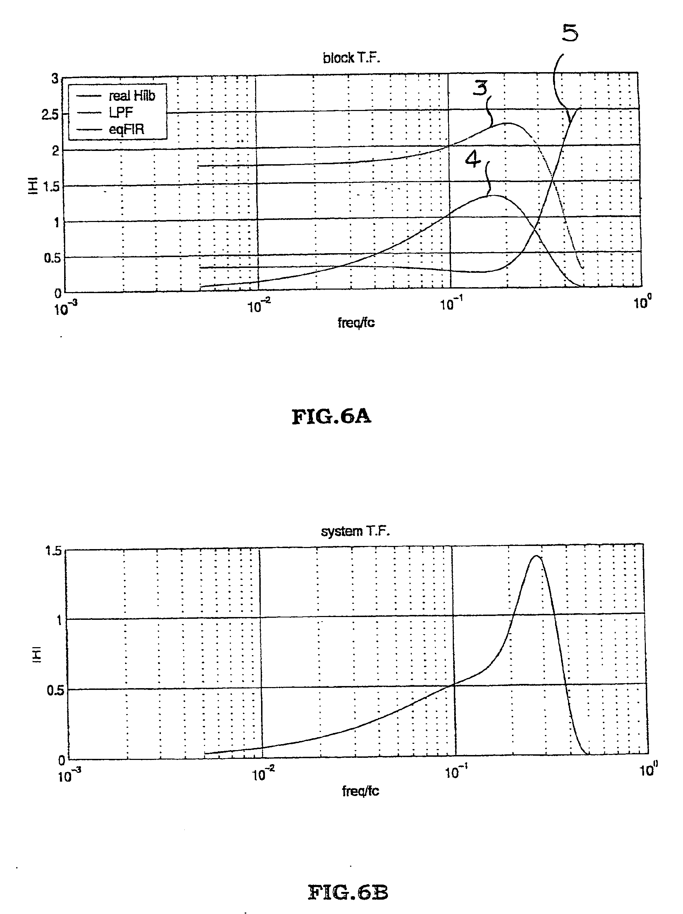

Reference can be made to the graph in Figure 6A, which shows a curve 3 relating to the transfer function of the low-pass filter, a curve 4 for the equalizer function, and a curve 5 for the Hilbert filter FIR.

With this solution, the value of the coefficients of the filter FIR which reproduce the Hilbert transform becomes a function of the input signal spectrum, which spectrum is dependent on the stored data packing density.

Thus, the values of FIR would have to be modified according to the more or less inwardly located track of the magnetic storage medium which contains the information to be read, since the density of the stored information, and with it the signal spectrum, is dependent on which track is being read.

Advantageously, this invention provides instead for a modification of the delay value Td of the cells which comprise the filter.

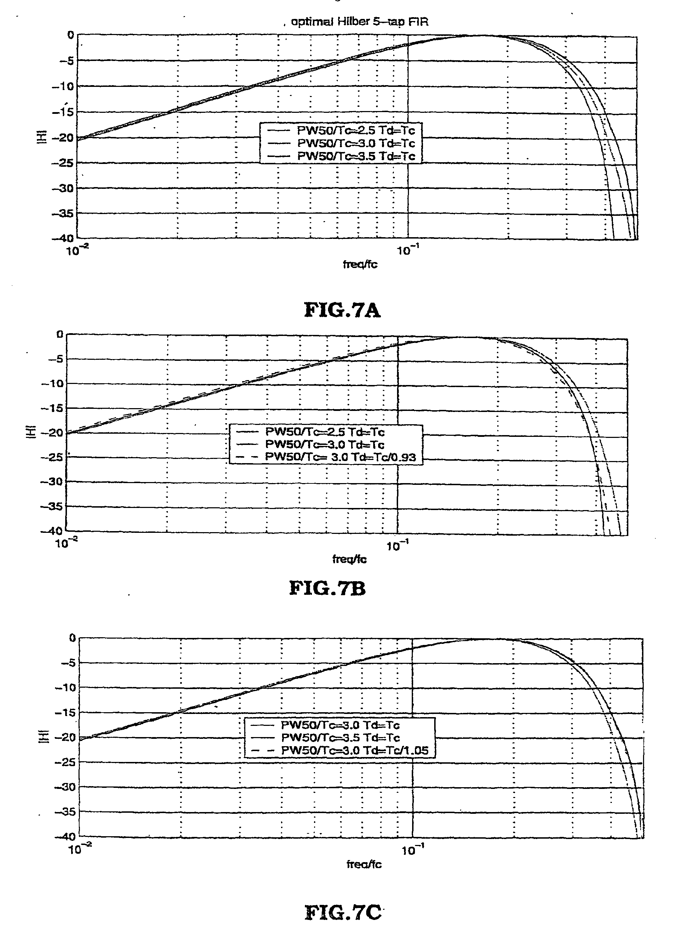

Td is the value of the delay element of each cell in the time-continous filter FIR. As can be appreciated from Figures 7B and 7C, to program the delay value Td is to program the values of the coefficients c0,...,cn of the time-continuous filter FIR. In these figures, Tc is the inverse channel period of the working frequency fc, which changes with the position of the read/write head on the magnetic storage medium.

Thus, according to the invention, a FIR with fixed coefficients can be used, and use can be made of the programmed delay Td=k*Tc to obtain a desired frequency response according to the different storage densities.

Plotted in Figure 7A is the transfer function of a Hilbert transform approximated for three different storage densities.

It will be appreciated from the foregoing that the filter and filtering method of this invention have a major advantage in that they allow data to be read from magnetic storage media used in the perpendicular recording mode, at the expense of only minor modifications in current apparatus for reading information from such magnetic storage media.

## Claims

1. A decoding arrangement of the PRML type including a cascade of signal processing blocks including an amplifier (VGA), a low-pass filter (LPF), an analog-to-digital converter (ADC) and an equalizer (eqFIR), **characterized in that** a IIilbert FIR filter is provided between said amplifier (VGA) and said low-pass filter (LPF) and includes a cascade of delay cells connected between an input terminal of the filter and an output terminal having constant filter coefficients (c0,...,cn) and a programmable time delay (Td) of the programmable filter cells.

2. A decoding arrangement according to Claim 1, **characterized in that** the length of said coefficients (c0,...,cn) is comparable to that of programmable coefficients.

3. A decoding arrangement according to Claim 1, **characterized in that** the value of said coefficients (c0,...,cn) of the Hilbert FIR filter is a function of the spectrum of the filter input signals.

4. A decoding arrangement according to Claim 1, **characterized in that** said delay (Td) is programmable for each cell.

5. A method of filtering signals whose spectra are unknown a priori, of the type comprising the sequential steps of processing the signal through amplification, low-pass filtering, analog-to-digital conversion, and equalization, **characterized in that** a step of processing the signal through a Hilbert FIR filter is carried out between the amplifying and low-pass filtering steps.

6. A method according to Claim 5, **characterized in that** said Hilbert FIR filter comprises a cascade of delay cells being connected between an input terminal of the filter and an output terminal and having a time delay (Td) which can be programmed to suit the spectrum of the input signal.

7. A method according to Claim 6, **characterized in that** said time delay (Td) is related to a channel period (Tc) being the inverse of the working frequency (fc) according to a variable (k), being itself a function of the input signal spectrum.

8. A method according to Claim 5, **characterized in that** said Hilbert FIR filter has constant filter coefficients (c0, ... ,cn).

9. A method according to Claim 5, **characterized in that** said sequential signal processing is a PRML type of processing.

## Patentansprüche

1. PRML-Dekodieranordnung mit einer Kaskade von Signalverarbeitungsblöcken die einen Verstärker (VGA), einen Tiefpass-Filter (LPF), einen analog-nach-digital Wandler (ADC) und einen Ausgleicher (eqFIR) einschließt, **dadurch gekennzeichnet, dass** zwischen dem Verstärker (VGA) und dem Tiefpass-Filter (LPF) ein Hilbert-FIR-Filter angeordnet ist und eine Kaskade von Verzögerungszellen zwischen einem Eingangsanschluss des Filters und einem Ausgangsanschluss, der konstante Filterkoeffizienten (c0,....,cn) und eine programmierbare Zeitverzögerung (Td) der programmierbaren Filterzellen besitzt, eingeschlossen sind.

2. Dekodieranordnung nach Anspruch 1, **dadurch gekennzeichnet, dass** die Länge der Koeffizienten (c0,...,cn) vergleichbar mit der von programmierbaren Koeffizienten ist.

3. Dekodieranordnung nach Anspruch 1, **dadurch gekennzeichnet, dass** der Wert der Koeffizienten (c0,...,cn) des Hilbert-FIR-Filters eine Funktion des Spektrums des Filtereingangssignals ist.

4. Dekodieranordnung nach Anspruch 1, **dadurch gekennzeichnet, dass** die Verzögerung (Td) für jede Zelle programmierbar ist.

5. Verfahren zur Filterung von Signalen deren Spektra a priori unbekannt sind, nach der Art, dass es sequentielle Schritte der Signalverarbeitung durch Verstärkung, Tiefpass-Filterung, analog-nach-digital Wandlung und Ausgleichung umfasst, **dadurch gekennzeichnet, dass** ein Signalverarbeitungsschritt durch einen Hilbert-FIR-Filter zwischen dem Verstärkungs- und den Tiefpass-Filterungsschritten ausgeführt wird.

6. Verfahren nach Anspruch 5, **dadurch gekennzeichnet, dass** der Hilbert-FIR-Filter umfasst eine Kaskade von Verzögerungszellen, die zwischen einem Eingangsanschluss des Filters und einem Ausgangsanschluss angeschlossen sind und eine Zeitverzögerung (Td), die dem Spektrum des Eingangssignal passend programmiert werden kann.

7. Verfahren nach Anspruch 6, **dadurch gekennzeichnet, dass** die Zeitverzögerung (Td) auf eine Kanalperiode (Tc) bezogen ist, die das Inverse der Arbeitsfrequenz (fc) nach einer Variable (k) ist, die selbst eine Funktion des Eingangssignalspektrums ist.

8. Verfahren nach Anspruch 5, **dadurch gekennzeichnet, dass** der Hilbert-FIR-Filter konstante Filterkoeffizienten (c0,...,cn) hat.

9. Verfahren nach Anspruch 5, **dadurch gekennzeichnet, dass** die sequentielle Signalverarbeitung der Art der PRML-Verarbeitung ist.

## Revendications

1. Un arrangement de décodage du type PRML comprenant une cascade de blocs de traitement de signal incluant un amplificateur (VGA), un filtre passe-bas (LPF), un convertisseur analogique-numérique (ADC) et un égaliseur (eqFIR), **caractérisé en ce qu'**un filtre de Hilbert FIR (Réponse Finie impulsionnelle) est prévu entre ledit amplificateur (VGA) et ledit filtre passe-bas (LPF) et comprend une cascade de cellules à retard, connectées entre une borne d'entrée du filtre et une borne de sortie, ayant des coefficients de filtre (c0,..., cn) constants et un retard temporel programmable (Td) des cellules de filtre programmables .

2. Un arrangement de décodage selon la revendication 1, **caractérisé en ce que** la longueur desdits coefficients (c0,..., cn) est comparable à celle de coefficients programmables.

3. Un arrangement de décodage selon la revendication 1, **caractérisé en ce que** la valeur desdits coefficients (c0,...,cn) du filtre de Hilbert FIR est une fonction du spectre des signaux d'entrée du filtre.

4. Un arrangement de décodage selon la revendication 1, **caractérisé en ce que** ledit retard (Td) est programmable pour chaque cellule.

5. Un procédé de filtrage de signaux, dont les spectres sont a priori inconnus, du type comprenant les étapes séquentielles de traitement du signal par amplification, filtrage passe-bas, conversion analogique-numérique et égalisation, **caractérisé en ce qu'**une étape de traitement du signal par un filtre de Hilbert FIR est effectuée entre les étapes d'amplification et de filtrage passe-bas.

6. Un procédé selon la revendication 5, **caractérisé en ce que** ledit filtre de Hilbert FIR comprend une cascade de cellules à retard, connectées entre une borne d'entrée du filtre et une borne de sortie, et ayant un retard temporel (Td) pouvant être programmé pour convenir au spectre du signal d'entrée.

7. Un procédé selon la revendication 6, **caractérisé en ce que** ledit retard temporel (Td) est lié à une période de canal (Tc), qui est l'inverse de la fréquence de travail (fc) selon une variable (k), qui est elle-même une fonction du spectre du signal d'entrée.

8. Un procédé selon la revendication 5, **caractérisé en ce que** ledit filtre de Hilbert FIR présente des coefficients de filtre (c0,..., cn) constants.

9. Un procédé selon la revendication 5, **caractérisé en ce que** ledit traitement de signal séquentiel est un type de traitement PRML.
